# EUROPÄISCHE PATENTANMELDUNG

(11) **EP 2 698 826 A2**
(43) Veröffentlichungstag der Anmeldung: **19.02.2014**
(21) Anmeldenummer: 13179110.5
(22) Anmeldetag: 02.08.2013
(51) Int. Cl.: H01L 31/0216, H01L 31/028, H01L 31/07

(54) **Solarzelle vom Schottkytyp mit plasmonisch aktiven Nanopartikeln**

(30) Priorität: 16.08.2012 DE 102012016532
(71) Anmelder: Helmholtz-Zentrum Berlin für Materialien und Energie GmbH, 14109 Berlin (DE)
(72) Erfinder: Lublow, Michael, 14109 Berlin (DE); Lörgen, Marcus, 15738 Berlin (DE); Nüsse, Nils Christian, 69118 Heidelberg (DE)

(57) **Zusammenfassung**

Solarzellen vom Schottkytyp erfahren eine Effizienzsteigerung durch eine Vielzahl von nanostrukturierten Emitterkontakten, die in die Absorberschicht hineinragen und zu einer geringeren Verschattung der Absorberschicht beitragen. Ansonsten werden nur rein optische Verbesserungsmaßnahmen durchgeführt. Bei der erfindungsgemäßen Solarzelle (00, 11) wird auch noch eine elektronische Effizienzverbesserung dadurch erreicht, dass zwischen den Emitterkontakten (03), die aus einem Metall mit keiner oder nur geringer plasmonischen Aktivität bestehen, plasmonisch hochaktive Nanopartikel (04) auf der Oberfläche der Absorberschicht (01) vorgesehen sind, die zu einer erhöhten Lichteinkopplung und zu einer verbesserten Lichtabsorption führen. Emitterkontakte (03) und plasmonisch aktive Nanopartikel (04) sind in eine transparente, elektrisch isolierende Isolationsschicht (02) auf der Absorberschicht (01) eingebettet, wobei die Nanopartikel (04) auch von dieser überdeckt sind und nicht in die Absorberschicht (01) hineinragen. Weiterhin ist unterhalb der plasmonisch aktiven Nanopartikel (04) einen gegenüber der Dotierkonzentration (N² _{D}) der Absorberschicht (01) erhöhte Dotierkonzentration (N¹ _{D}) vorgesehen ist, sodass in der Absorberschicht (01) ein laterales und vertikales Dotierprofil aufgebaut ist, dass zu einer verbesserten Ladungsträgerabfuhr über die Emitterkontakte (03) führt.

## Beschreibung

Die Erfindung bezieht sich auf eine Solarzelle mit einem elektrischen Festkörperkontakt vom Schottkytyp zwischen einer Absorberschicht aus einem Halbleitermaterial mit einer Dotierkonzentration eines Ladungsträgertyps und einer Vielzahl von Emitterkontakten aus einem Metall, die eine auf der Absorberschicht angeordnete transparente Isolationsschicht aus einem elektrisch nichtleitenden Material durchdringen und in die darunter liegende Absorberschicht hineinragen, wobei die Emitterkontakte auf der lichtzugewandten Oberseite der Isolationsschicht durch eine Frontkontaktierung elektrisch leitend miteinander verbunden sind, und mit einer Rückkontaktierung auf der lichtabgewandten Unterseite der Absorberschicht.

Bei der photovoltaischen Stromerzeugung ist die Effizienz der Umsetzung von Sonneneinstrahlung in elektrischen Strom von ausschlaggebender Bedeutung. Um eine optimale Ausbeute zu erhalten, werden in technischen Verbesserungen neben einer Verringerung der Reflexions- und Rekombinationsverluste insbesondere eine Verringerung der Abschattungsverluste und eine Verbesserung der Lichtsammlung angestrebt. Abschattungen der Lichteinstrahlfläche treten insbesondere auch durch die auf der lichtzugewandten Absorberseite liegende Emitterschicht bei Solarzellen vom Schottkytyp mit einem Festkörperkontakt zwischen der dotierten Halbleiterschicht (Absorber) und einer gleichrichtenden Metallschicht (Emitter) auf. Zur Verringerung der Abschattungsverluste kann daher die Emitterschicht in eine Vielzahl von einzelnen im Nanobereich strukturierten Emitterkontakten überführt werden, wobei die Anzahl der über die Absorberschicht gleichmäßig verteilten Emitterkontakte mit dem Ziel der Minimierung der beschattenden Kontaktfläche optimiert wird.

### Stand der Technik

Eine solche Solarzelle mit nanostrukturierten Emitterkontakten bildet die Gattung zur vorliegenden Erfindung und ist aus der DE 103 47 401 B4 bekannt. Bei der Solarzelle vom Schottkytyp wird der pn-Übergang aufgespannt zwischen der absorbierenden Halbleiterschicht mit einer Dotierkonzentration eines Ladungsträgertyps, also n-(negativ-) oder p-(positiv-) dotiert, und einem Metallemitter, der die photoinduzierten überschüssigen Minoritätsladungsträger aus der Absorberschicht abführt. Bei der bekannten Solarzelle ist der Emitter in eine Vielzahl von Nanoemitterkontakten aufgeteilt, die gleichmäßig über die Absorberschicht verteilt sind und in diese hineinragen. Dabei können die Nanoemitterkontakte plasmonisch aktiv oder auch nicht aktiv sein (abhängig von Größe und Material), wobei die plasmonische Aktivität aber von untergeordneter Rolle ist. Die Hauptfunktion aller Emitterkontakte besteht in der Sammlung und Ableitung von lichtgenerierten überschüssigen MinoritätsLadungsträgern aus der Absorberschicht. Auf der Absorberschicht ist eine transparente Isolationsschicht aus einem elektrisch nichtleitenden Material angeordnet, die von den Nanoemitterkontakten durchdrungen wird, sodass diese im Bereich der Isolationsschicht elektrisch gegeneinander isoliert sind. Auf der lichtzugewandten Oberseite der Isolationsschicht bzw. der Absorberschicht ist eine transparente leitfähige Oxidschicht (TCO) angeordnet, die zusammen mit streifen- oder punktförmigen Frontkontakten die Frontkontaktierung bilden. Über diese Frontkontaktierung sind die Emitterkontakte leitend miteinander verbunden und werden die eingesammelten überschüssigen Minoritäts-Ladungsträger abgeleitet (Stromfluss). Die Rückkontaktierung auf der lichtabgewandten Unterseite der Absorberschicht wird von einer Rückkontaktschicht in Form einer Metallschicht gebildet.

Zur weiteren Erhöhung der Umwandlungseffizienz von Licht in elektrischen Strom bei Solarzellen durch Verbesserung der Lichtsammlung ist es bekannt, den bei metallischen Festkörper-Nanopartikeln bestimmter Größe auftretenden "plasmonischen Effekt" zu nutzen. Die kollektive Anregung von freien Elektronen in Metallen (Grundvoraussetzung für das Auftreten plasmonischer Effekte ist das freie Elektronengas in metallischen Materialien) durch Lichteinfall zu Plasmaschwingungen gegen die Ionenrümpfe wird als "Plasmon" bezeichnet. "Oberflächenplasmonen" sind Oberflächenwellen, die sich entlang der Metalloberfläche ausbreiten, wobei ihre Intensität mit der Ausbreitungslänge exponentiell abnimmt (evaneszente Oberflächenwellen). Lokalisierte Oberflächenplasmonen beschreiben das resonante Verhalten metallischer Partikel. Die Energien, für welche lokalisierte Oberflächenmoden auftreten, sind diskret und streng mit der Geometrie des betrachteten Teilchens verknüpft. Solange die Teilchenumfänge in der Größenordnung der Wellenlängen von Oberflächenmoden liegen, bilden diese Moden stehende Wellen auf der Partikeloberfläche aus, die den diskreten Schwingungsmustern entsprechen. Die resultierende Feldstärke ist im Raum über der metallischen Oberfläche verstärkt. Eine extreme Verstärkung (bis Faktor 105) tritt auf, wenn die Plasmonen in Resonanz mit dem eingestrahlten Licht schwingen. Die Resonanz ist durch die Wahl der Wellenlänge, Form, Abmessungen und Anordnung der Nanopartikel sowie durch deren chemische Natur beeinflussbar. Die Anregung von Elektronendichte-Oszillationen der Leitungselektronen in diesen Nanopartikeln durch Licht einer Wellenlänge typischerweise außerhalb des Resonanzbereichs kann auch bereits zu einer erhöhten Lichteinkopplung in die darunter liegende Absorberschicht führen und/oder die Lichtabsorption direkt unterhalb der Oberfläche erhöhen. Die Erzeugungsrate von photoinduzierten überschüssigen Ladungsträgern (Minoritätsladungsträger), gemittelt über den Absorberquerschnitt, wird damit gesteigert und/oder örtlich (unterhalb der Oberfläche) intensiviert.

Die Verwendung plasmonisch aktiver Nanostrukturen aus Metallen mit freiem Elektronengas zur deutlichen Effizienzsteigerung bei Solarzellen ist beispielsweise aus der US 2007/0289623 A1 bekannt. Eine Übersicht auf dem Gebiet der plasmonischen Photovoltaik ist in dem neuesten Report der **GCEP** zusammengefasst (vergleiche Global Climate and Energy Project GCEP Final Report May 2012 - Plasmonic Photovoltaics, A. Polman et al.). Gegenstände der aufgezeigten Problemlösungen sind Materialauswahl, Form der Partikel sowie die geometrische Anordnung der Partikel. Damit werden spezifische optische Problemstellungen gelöst, wie beispielweise die plasmonische Resonanzlage und -breite bzw. Effekte höherer Ordnung.

In der US 2011/0197959 A1 ist eine Lösung aufgezeigt (vergleiche Figur 2 ebenda), bei der metallische Kontaktfinger aus Aluminium auf der Oberseite einer n-dotierten Absorberschicht in einer solchen Weise nanostrukturiert ausgebildet sind, dass bei Lichteinfall auch Plasmone ausgebildet werden. Unterhalb der Kontaktfinger werden pn-Übergänge ausgebildet, indem durch Kontaktfeuern Aluminiumatome aus den Kontaktfingern in die Absorberschicht hineindiffundieren. Es entstehen in der n-dotierten Absorberschicht p-dotierte Zonen, die ohmsche Kontakte zu den Kontaktfingern ausbilden. Die Kontaktfinger üben somit eine Mehrfachfunktion aus, wobei über die elektronische Funktion der Plasmonen keine weiteren Aussagen gemacht werden. Zwingend ist jedoch, dass die plasmonisch aktiven Emitterkontakte die erzeugten überschüssigen Minoritätsladungsträger anziehen und nicht abstoßen. Daneben wird in anderen Druckschriften die optische Charakteristik des die Nanopartikel umgebenden Mediums genauer berücksichtigt bzw. modifiziert, um die erwünschten Resonanzeffekte z.B. durch so genannte "spacer", d.h. dielektrische Schichten zwischen den plasmonischen Partikeln und dem Absorber, weiter zu steigern, vergleiche beispielsweise die US 2011/0235184 A1**.**

Weiterhin ist es aus der US 2010/0006144 A1 bekannt, durch eine Dotierung eine Beschleunigung von lichtgenerierten überschüssigen Ladungsträgern in Richtung auf einen plasmonisch aktiven Metallfilm hervorzurufen. Ein plasmonisch aktiver durchgängiger Film führt zu den so genannten "propagierenden Plasmonenresonanzen", bei denen durch die Geometrie (Zick-Zack-Muster) stehende Wellen erzeugt werden, die eine Vermischung der optischen Anregung und des Stromflusses in der plasmonisch aktiven Schicht hervorrufen. Durch diese Mischung der beiden Funktionen kann es vermehrt zu Rekombinationen und damit zu einer Effizienzverringerung kommen. Weiterhin wird ausgeführt, dass die Größe der Verarmungszone prinzipiell von der Dotierungsstärke abhängig ist und die Dotierungsstärke in Abhängigkeit von der Eindringtiefe des eingestrahlten Licht so ausgewählt wird, dass die eingestrahlte Lichtenergie maximal in die Erzeugung von überschüssigen Ladungsträger-Paaren umgesetzt werden kann. Hierbei handelt es sich um allgemeines Fachwissen.

Während bei den bekannten Ansätzen die optische Architektur im Vordergrund steht, also Fragen der effizienten Lichteinkopplung in den Absorber und der örtlich verstärkten Generation von überschüssigen Ladungsträgern (Elektronen-Loch-Paare), werden jedoch die elektronischen Aspekte einer modifizierten Halbleiter-Bandstruktur nicht in das optimierte Design miteinbezogen. Dies ist jedoch ein wichtiger Aspekt eines notwendigen Gesamtkonzepts, um neben der erhöhten Erzeugungsrate auch einen effizienten Transport der überschüssigen Ladungsträger zu gewährleisten.

### Aufgabenstellung

Die **Aufgabe** für die vorliegende Erfindung ist daher darin zu sehen, die eingangs beschriebene gattungsgemäße Solarzelle vom Schottkytyp so weiterzubilden, dass die Effizienz der Umsetzung von Sonneneinstrahlung in elektrischen Strom weiter gesteigert wird. Dabei sollen insbesondere die elektronischen Aspekte der Solarzelle im Vordergrund stehen. Die Lösung für diese Aufgabe ist dem Hauptanspruch zu entnehmen. Vorteilhafte Modifikationen der erfindungsgemäßen Solarzelle werden in den Unteransprüchen aufgezeigt und im Nachfolgenden im Zusammenhang mit der Erfindung näher erläutert.

Die erfindungsgemäße Solarzelle ist dadurch gekennzeichnet, dass auf der Absorberschicht zwischen den Emitterkontakten, die aus einem Metall mit keiner oder nur geringer plasmonischen Aktivität |α|ₘₐₓ in einem Bereich zwischen 1,0 und 1,2 bestehen, eine Vielzahl von Nanopartikeln, die aus einem Metall mit einer hohen plasmonischen Aktivität |α|ₘₐₓ in einem Bereich zwischen 1,5 und 6,2 bestehen, angeordnet und von der Isolationsschicht umgeben und überdeckt sind, wobei die Nanopartikel nicht in die Absorberschicht hineinragen, und unterhalb der plasmonisch aktiven Nanopartikel in der Absorberschicht eine gegenüber der Dotierkonzentration der Absorberschicht höhere Dotierkonzentration desselben Ladungsträgertyps vorgesehen ist, wohingegen unterhalb der Emitterkontakte die unveränderte Dotierkonzentration der Absorberschicht belassen ist.

Bei der erfindungsgemäßen Solarzelle vom Schottkytyp mit metallischen Emitterkontakten werden in der die Emitterkontakte, die plasmonisch nicht oder nur wenig aktiv sind, umgebenden Isolationsschicht zusätzlich Nanopartikel angeordnet, die aufgrund ihres Materials und ihrer Abmessungen plasmonisch stark aktiv sind. Dadurch werden die Funktionen der Anregung und des Stromflusses örtlich klar getrennt: Die Emitterkontakte dienen dem Stromfluss, die plasmonisch aktiven Nanopartikel dienen der vermehrten optischen Anregung und damit der verbesserten Absorption. Plasmonische Aktivität (von Partikeln mit Durchmessern kleiner als die Wellenlänge(n) des sichtbaren Lichts) kann anhand der vereinfachten (volumenunabhängigen) Fröhlich-Bedingung für die Polarisierbarkeit dieser Teilchen quantifiziert werden (siehe z.B. Stefan A. Mayer, Plasmonics: Fundamentals and Applications", Springer 2007, Seite 68). Die Gleichung (5.7): α=(ε-ε_{M})/(ε+2ε_{M}) (zur Vereinfachung in auf das Partikelvolumen bezogener normierter Form, daher ohne konstanten Faktor) stellt in der elektrostatischen Näherung die Polarisierbarkeit der Teilchen dar, wobei ε die dielektrische Funktion des verwendeten Metalls und ε_{M} die entsprechende dielektrische Funktion der Umgebung (z.B. Luft) bezeichnen. Über das Maximum des Absolutbetrags dieser Größe (|α|ₘₐₓ) lassen sich nun plasmonisch nicht bis weniger aktive von plasmonisch aktiveren Metallen unterscheiden. So gilt für das besonders aktive Silber |α|ₘₐₓ ≈ 6, für Gold |α|ₘₐₓ ≈ 1,8 und für das wenig aktive Platin |α|ₘₐₓ ≈ 1,1. Für die Emitterkontakte kommen bei der Erfindung daher Metalle infrage, für die |α|ₘₐₓ nahe bei 1 liegt, während für die plasmonisch aktiven Partikel solche Metalle mit |α|ₘₐₓ > 1,5 verwendet werden.

Die bei Einfall von Sonnenlicht verstärkte Lichteinkopplung in den Absorber durch Auftreten plasmonischer Effekte trägt bereits zur Effizienzsteigerung der Solarzelle bei. Eine weitere Effizienzsteigerung wird bei der erfindungsgemäßen Solarzelle dadurch erreicht, dass ein lateral und vertikal variiertes Dotierprofil in der Absorberschicht direkt unterhalb der Metall-Strukturen aus metallischen Emitterkontakten und metallischen plasmonisch aktiven Nanopartikeln aufgebaut ist, das eine verbesserte Ableitung der überschüssigen Minoritätsladungsträger über die Emitterkontakte bei einer geringen Rekombinationsrate bedingt. Unterhalb der Emitterkontakte liegt die unveränderte Dotierung der Absorberschicht vor, die sich in einem niedrigen bis mittleren Konzentrationsbereich bewegt. Dadurch ergibt sich bei der erfindungsgemäßen Solarzelle ein laterales Dotierprofil entlang der Oberfläche der Absorberschicht, das mit der alternierenden Anordnung von Nanopartikeln und Emitterkontakten korreliert ist. Diesem lateralen Dotierprofil ist in der Absorberschicht ein vertikales Dotierprofil unterhalb der plasmonisch aktiven Nanopartikel vom hochdotierten Bereich in den mittel bis niedrig dotierten Bereich der Absorberschicht überlagert. Das Konzept der erfindungsgemäßen Solarzelle basiert auf der Korrelation der örtlich erhöhten Ladungsträgergeneration durch die Plasmonen mit den örtlich modifizierten Raumladungsgeometrien durch die Dotierungsprofile. Die profiliert dotierte Absorberschicht und die Isolationsschicht mit den Emitterkontakten und den plasmonisch aktiven Nanopartikeln bilden einen sowohl in optischer als auch speziell in elektronischer Hinsicht optimierten aktiven Schichtenverbund.

Bei der mit der Erfindung beanspruchten Lösung werden die als Schottky-Kontakte wirkenden ohmschen Emitterkontakte, die für den Stromtransport der Minoritätsladungsträger (je nach Dotierung Elektronen oder Defektelektronen (Löcher)) senkrecht zur Grenzfläche zur Absorberschicht eingesetzt werden, und die ebenfalls als Schottky-Kontakte wirkenden metallischen Nanopartikel, die zur plasmonisch erhöhten Elektron-Loch-Paar-Generation dienen, durch Verwendung unterschiedlicher Materialien, einer Isolationsschicht und eines modulierten Dotierprofils innerhalb der Absorberschicht funktionell voneinander getrennt. Eine Störung der für die oberflächennahe Elektron-Loch-Paar Erzeugung verantwortlichen Elektronendichte-Oszillationen der Leitungselektronen (Oberflächenplasmonen) der plasmonisch aktiven Partikel durch die zum Teil erheblichen lokalen Stromdichten durch die Partikel-Grenzflächen wird bei der Erfindung dadurch vermieden, dass die überschüssigen Minoritätsladungsträger über ein lokal variiertes Dotierprofil zu den Emitterkontakten lateral hin beschleunigt werden und sich von dort - entsprechend den gegebenen räumlichen Bandverbiegungen - hin zur Oberfläche der Isolationsschicht bewegen. Dort werden sie über die Frontkontaktierung abgeleitet. Die Majoritätsladungsträger werden mehrheitlich in unveränderter Weise durch die Absorberschicht hindurch senkrecht zur Oberfläche hin zum Rückkontakt beschleunigt und dort von der Rückkontaktierung abgeleitet. Damit können optische und elektronische aber auch chemische, die Langzeitstabilität betreffende Aspekte der erfindungsgemäßen Solarzelle getrennt voneinander betrachtet, modifiziert und optimiert werden.

Grundsätzlich kann bei der Solarzelle nach der Erfindung für die Absorberschicht jedes dotierfähige Material eingesetzt werden. Dabei kann es sich sowohl um eine p- (positive) als auch um eine n- (negative) Dotierung vorgegebener Dotierkonzentration handeln. Vorteilhaft und bevorzugt kann für die Absorberschicht kristallines Silizium als Halbleitermaterial mit einer mittleren Dotierkonzentration des n-Ladungsträgertyps in einem Bereich zwischen 10¹⁵ und 10¹⁶ Elektronen / cm³ eingesetzt werden (negative Dotierung). Dabei kann die Siliziumschicht als Dickschicht-Wafer oder bevorzugt und vorteilhaft als Dünnschicht ausgeführt sein. Unterhalb der plasmonisch aktiven Nanopartikel ist dann ebenfalls eine negative Dotierung, dann jedoch mit gegenüber der mittleren Dotierkonzentration in der Absorberschicht erhöhter Konzentration vorgesehen. Bevorzugt und vorteilhaft kann unterhalb der plasmonisch aktiven Nanopartikel eine Dotierkonzentration des n-Ladungsträgertyps in einem Bereich zwischen 10¹⁷ und 10¹⁸ Elektronen / cm³ vorgesehen sein. Analoges gilt für eine p-Dotierung der Absorberschicht.

Die transparente Isolationsschicht auf der Absorberschicht hat verschiedene Aufgaben. Zum einen muss sie die verschiedenen Schottky-Kontakte (Emitterkontakte und plasmonisch aktive Nanopartikel) elektrisch gegeneinander isolieren. Zum anderen gewährt die chemisch inerte und nicht-leitende Umgebung der Isolationsschicht Schutz vor einer (elektro-) chemischen Degradation der plasmonisch aktiven Nanopartikel im Langzeitbetrieb. Weiterhin kann durch Variation von Brechungsindex und Schichtdicke der Isolationsschicht eine Optimierung des optischen Gesamtverhaltens der Solarzelle vorgenommen werden. Eine Isolationsschicht aus einem Oxid, beispielsweise ZnO, SnO₂ oder ITO, erfüllt diese Bedingungen bereits. Bevorzugt und vorteilhaft kann als Material für die Isolationsschicht aber auch ein transparentes, elektrisch nichtleitendes Polymer gewählt sein, wobei der Brechungsindex des Polymers größer oder gleich 1,5 (bevorzugt gleich 2) ist. Der Brechungsindex und die Dicke der Isolationsschicht sind dabei so gewählt, dass die über das Sonnenlichtspektrum gemittelte Lichteinkopplung maximal und die durch die Nanopartikel plasmonisch verstärkte Lichtabsorption hin zur Bandkante des Materials der Absorberschicht hin verschoben ist.

Durch die Verwendung eines Metalls für die Emitterkontakte entsteht ein Schottky-Kontakt. Dabei ist das Metall so auszuwählen, dass ein zur Absorberschicht gleichrichtender Kontakt gebildet wird. Für p-dotiertes Halbleitermate-rial ist somit zur Erzeugung des Photostroms ein Metall mit einer niedrigen Austrittsarbeit, für n-dotiertes Halbleitermaterial ein Metall mit einer höheren Austrittsarbeit zu wählen. Weiter oben wurde bereits erwähnt, dass die Grundvoraussetzungen für das Auftreten von plasmonischen Effekten in der Partikelgröße und in dem Partikelmaterial liegen. Dabei muss im Partikelmaterial ausreichend freies Elektronengas auftreten. Die Emitterkontakte bei der Solarzelle nach der Erfindung sind nicht oder nur gering plasmonisch aktiv, d.h., dass sie eine solche Größe und/oder ein solches Material aufweisen, dass sie nur eine unbedeutsame plasmonische Aktivität aufweisen. Dabei soll der Begriff "unbedeutsam" darauf hinweisen, dass eine ggfs. auftretende plasmonische Aktivität nicht zur Verbesserung der Effizienz bei der Solarzelle nach der Erfindung beiträgt, wohingegen eine "bedeutsame" plasmonische Aktivität zur Effizienzsteigerung beiträgt. Dabei ist aber anzumerken, dass die optische Gesamtaktivität der Solarzelle natürlich durch Emitterkontakte mit aufgrund ihres Materials und ihrer Größe eigener plasmonischer Aktivität zusätzlich variiert bzw. weiter optimiert werden kann. Bevorzugt und vorteilhaft kann aber für die Emitterkontakte Platin (|α|ₘₐₓ ≈1,1) als Edelmetall ohne ausgeprägte plasmonische Aktivität im sichtbaren Lichtbereich eingesetzt werden. Alternativ kann es sich bevorzugt und vorteilhaft bei dem Material für die plasmonisch aktiven Nanopartikel um Gold (|α|ₘₐₓ ≈1,8), Silber (|α|ₘₐₓ ≈ 6,0), Kupfer oder Aluminium als Metall mit ausgeprägter plasmonischer Aktivität im sichtbaren Lichtbereich handeln.

Die Erzeugung der Emitterkontakte in technologischen Anwendungen kann durch die Strukturierung der Isolationsschicht mit mikrotechnischen Verfahren wie beispielsweise Elektronenstrahllithographie oder Ionenstrahlätzen durchgeführt werden. Alternativ, aber auch ohne Anwendung von hohen Temperaturen kann die Strukturierung der Isolationsschicht auch mittels Rastersondenmikroskopie durch Wegschieben oder Durchstechen der Isolationsschicht (Indentation mit einer Diamantnadel) erfolgen, wodurch eine noch genauere und kontrolliertere Festlegung der Emitterpositionen möglich ist. Dabei können die Emitterkontakte als Nanoemitterkontakte mit Abmessungen im Nanobereich (Durchmesser einige nm) ausgebildet sein, die in Nanoporen in der Absorberschicht und der Isolationsschicht eingebracht sind. Das Einbringen der plasmonisch aktiven Nanopartikel auf die Absorberschicht kann beispielsweise durch Aufbringen eines feinen Metallpulvers aus einer kolloidalen Lösung oder durch elektrochemische Abscheidung erfolgen.

Durch die vorbeschriebenen Maßnahmen in Form des Vorsehens von Nanoemitterkontakten und plasmonisch aktiven Nanopartikeln kann die Umsetzungseffizienz der Solarzelle nach der Erfindung von eingestrahltem Sonnenlicht in elektrischen Strom gesteigert werden. Mehr überschüssige Ladungsträger werden erzeugt und abgeführt. Zur guten Abführung der erzeugten überschüssigen Ladungsträger ist es vorteilhaft und bevorzugt, wenn die Frontkontaktierung von einer transparenten, elektrisch leitfähigen Oxidschicht (TCO, beispielsweise ITO) und darauf angebrachten Frontkontakten, beispielsweise aus Gold oder Silber, und die Rückkontaktierung von einer metallischen Rückkontaktfläche, beispielsweise aus Aluminium, gebildet ist. Die Solarzelle nach der Erfindung kann sowohl als photoelektrisches System zur direkten Stromerzeugung als auch als photoelektrochemisches System zur Brennstofferzeugung eingesetzt werden.

Die Brüchigkeit kristalliner Si-Wafer gestattet im Allgemeinen nicht ihre Verwendung als Material für flexible Solarzellen. Desweiteren kann daher vorteilhaft und bevorzugt bei der Solarzelle nach der Erfindung die Absorberschicht in Waferausbildung in einzelne Einzelsegmente aufgeteilt sein, die matrixartig mit Abständen zueinander in eine flexible, elektrisch leitfähige Polymerschicht eingelagert sind. Durch die Segmentierung des Wafers und Einbettung in eine flexible und leitfähige Polymerschicht kann eine solche Modifikation der Solarzelle nach der Erfindung erzielt werden, bei der die Elastizität der Solarzelle von der Größe der Einzelsegmente und deren wechselseitigem Abstand bestimmt wird. Somit kann quasi eine flexible Solarzelle erzeugt werden. Weitere Details hierzu und zu den voranstehend aufgezeigten Modifikationen sind den Ausführungsbeispielen zu entnehmen.

### Ausführungsbeispiele

Die Solarzelle nach der Erfindung mit Nanoemitterkontakten und plasmonisch aktiven Nanopartikeln und einem damit korrelierten Dotierungsprofil in der Absorberschicht mit ihren möglichen Modifikationen wird nachfolgend anhand der schematischen Figuren zum weiteren Verständnis der Erfindung näher erläutert. Dabei zeigt:
- **Figur 1**: einen schematischen Querschnitt durch die Solarzelle,
- **Figur 2**: ein Banddiagramm zur Verlaufsdarstellung der Elektronen zwischen den unterschiedlich dotierten Raumladungszonen,
- **Figur 3**: den Verlauf der Bänder im Metall-Halbleiterkontaktbereich für eine n-dotierte Absorberschicht,
- **Figur 4**: den Bewegungsverlauf der Löcher in der n-dotierten Absorberschicht,
- **Figur 5**: den errechneten Bewegungsverlauf der Löcher in der n-dotierten Absorberschicht,
- **Figur 6**: das berechnete optische Verhalten der Absorberschicht ohne (links) und mit (rechts) Isolationsschicht,
- **Figur 7**: Aufsicht (oben) und Querschnitt (unten) durch eine flexible Solarzelle nach der Erfindung,
- **Figur 8**: eine REM-Aufnahme von abgeschiedenen Au-Nanopartikeln,
- **Figur 9**: ein Diagramm zum Stromdichteverlauf,
- **Figur 10**: eine REM-Aufnahme einer Absorberschicht mit Emitterkontakten,
- **Figur 11**: ein Diagramm zum Reflexionsvermögen der Oberfläche und
- **Figur 12**: ein Strom-Spannungsdiagramm einer fertigen Solarzelle nach der Erfindung.

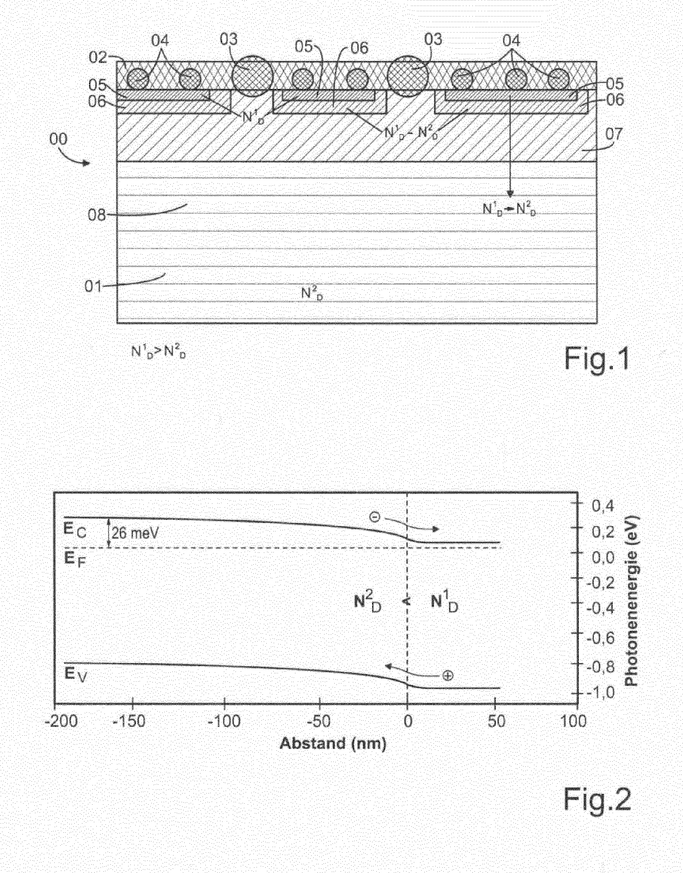

Die **Figur 1** zeigt schematisch einen Querschnitt durch die Solarzelle **00** nach der Erfindung. Auf einer Absorberschicht **01** aus n-dotiertem (in einem Bereich zwischen 10¹⁵ und 10¹⁶ Elektronen / cm³) kristallinem Silizium ist eine transparente, elektrisch nicht leitende Isolationsschicht **02** aus einem Polymer aufgebracht. Die Isolationsschicht **02** wird durchdrungen von Emitterkontakten **03.** Weiterhin sind auf der Absorberschicht **01** plasmonisch aktive Nanopartikel **04** angeordnet. Emitterkontakte **03** und Nanopartikel **04** sind elektrisch durch die Isolationsschicht **02** voneinander isoliert. Die Absorberschicht **01** weist eine niedrige bis mittlere negative Dotierkonzentration N²_{D} auf. Unterhalb der plasmonisch aktiven Nanopartikel **04** sind Raumladungszonen **05** mit einer hohen negativen Dotierkonzentration N¹_{D} vorgesehen. Es gilt N¹_{D} > N²_{D}. Zwischen der niedrigen bis mittleren Dotierkonzentration und der hohen Dotierkonzentration ergibt sich ein Dotiergradient. Eingezeichnet sind weitere Raumladungszonen **06,** in denen die Dotierkonzentration zwischen N¹_{D} und N²_{D} liegt. Es gilt N¹_{D}- N²_{D}. In der **Figur 1** ist eine Front-Raumladungszone **07** angedeutet, die sich durch die höhere Dotierkonzentration N¹_{D} in der Absorberschicht **01** einstellt und sich an einen Absorberbereich **08** mit unveränderter niedriger bis mittlerer Dotierkonzentration N²_{D} anschließt.

In der **Figur 2** ist die in **Figur 1** aufgezeigte Verteilung der einzelnen Raumladungszonen schematisch erläutert. Die **Figur 2** zeigt ein Banddiagram (Energie in eV über dem Abstand in nm) zur Darstellung des Verlaufs der potenziellen Energie der Elektronen an dem Übergang zwischen höherer n-Dotierkonzentration (N¹_{D}) und niedrigerer n-Dotierkonzentration (N²_{D}). Lichtgenerierte Löcher bewegen sich in dieser Darstellung "bergauf", d.h. nach links vom Kontaktbereich aus betrachtet. Die **Figur 2** zeigt den Energieverlauf parallel zur Oberfläche der Absorberschicht **01.**

Die Bestimmung des Verlaufs von Leitungs- und Valenzbändern im N¹_{D} - N²_{D} - Übergangsbereich (Raumladungszonen **06**) folgt der so genannten "full depletion approximation", d.h. unter der Annahme der vollständigen Ladungsträgerverarmung in den jeweiligen Bereichen höherer bzw. niedrigerer Dotierung. Diese Annäherung ist für nicht zu hohe Dotierungen anwendbar, d.h. sofern das in **Figur 2** gezeigte Ferminiveau einige kT (26 meV bei Raumtemperatur) von der Leitungsbandkante entfernt ist. Das Kontaktpotenzial fällt überwiegend im niedriger dotierten Bereich ab. Ladungsträger, die dort lichtgeneriert werden, werden nach links (Löcher) bzw. nach rechts (Elektronen) hin beschleunigt. Für das oben aufgezeigte Ausführungsbeispiel der Erfindung (n-dotierte Silizium-Absorberschicht **02**) bedeutet dies, dass unterhalb der plasmonischen Nanopartikel **04** lichtinduzierte Löcher in niedriger dotierte Bereiche beschleunigt werden. Dieser Effekt unterstützt die gute Ableitung überschüssiger p-Ladungsträger durch die Absorberschicht 01 bei der Solarzelle **00.**

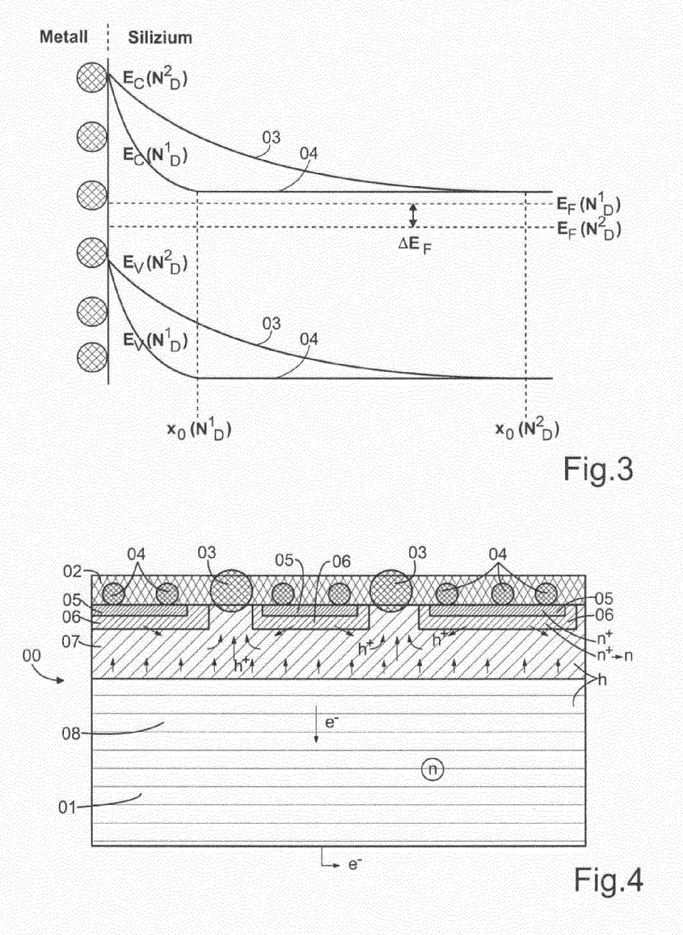

Die **Figur 3** zeigt den Verlauf der Bänder im Metall-Halbleiterkontaktbereich für das niedrig-/mittel- bzw. hochdotierte Silizium. Es sind den in **Figur 2** dargestellten Bandverbiegungen die Raumladungszonen **05, 06,** die sich durch die jeweiligen Metall-Halbleiter-Kontakte (Schottky-Kontakte) ergeben, überlagert (jeweils obere Kurve: Emitterkontakte **03,** untere Kurve: Kontakte der plasmonisch aktiven Nanopartikel **04**)**.** Die **Figur 3** zeigt den Energieverlauf senkrecht zur Oberfläche der Absorberschicht 01. Die jeweiligen Weiten der Raumladungszonen **05, 06** sind mit x₀(N¹_{D}) bzw. x₀(N²_{D}) bezeichnet. Die eingezeichnete Lage der Ferminiveaus E_{F}(N¹_{D}), E_{F}(N²_{D}) deutet an, dass - im gewählten Ausführungsbeispiel mit einer n-dotierten Absorberschicht **01** aus Silizium - lichtinduzierte Löcher über den gesamten höher dotierten Bereich eine höhere potenzielle Energie besitzen und daher in den niedriger dotierten Bereich abgelenkt werden, was erwünscht ist. Auch hier ist ebenfalls der weitere positive Effekt zu erkennen, dass durch die höhere Dotierkonzentration N¹_{D} unterhalb der plasmonisch aktiven Nanopartikel **04** eine Verbesserung der Ableitung der überschüssigen negativen Ladungsträger über die Emitterkontakte **03,** die im niedriger dotierten Bereich N²_{D} liegen, erzielt wird.

Werden zur Bestimmung der Bandverbiegungen plasmonisch aktive Nanopartikel **04** aus Gold (Au) und Emitterkontakte **03** aus Platin (Pt) mit den Schottky-Barrierehöhen 0,8 V bzw. 0,9 V sowie Dotierungen N¹_{D} = 10¹⁷ und N²_{D} = 10¹⁵ Elektronen / cm³ angenommen, so ergibt sich der in **Figur 3** wiedergegebene Verlauf der Bandverbiegungen. Da sich die Weiten der Raumladungszonen x₀(N¹_{D}) und x₀(N²_{D}) umgekehrt proportional zu den jeweiligen Dotierungen N¹_{D} und N²_{D} verhalten, fällt das Metall-Halbleiter-Kontaktpotenzial im höher dotierten Bereich (N¹_{D}) der Absorberschicht **01** aus Silizium schneller ab. Bandverbiegungen, die zu den in **Figur 2** angedeuteten Beschleunigungen von Löchern in Richtung des niedriger dotierten Bereichs (N²_{D}) führen, finden daher auch in den Bereichen zwischen x₀(N¹_{D}) und x₀(N²_{D}) statt.

Die vom Dotierprofil abhängige exakte räumliche Variation der Bandverbiegungen kann nicht mehr analytisch ermittelt werden. Mit den obigen Ergebnissen kann jedoch das Verhalten lichtgenerierter Löcher qualitativ wie in Figur **4** wiedergegeben werden. Die **Figur 4** zeigt die Bewegung der photoinduzierten Löcher h⁺ (bei n-dotiertem Silizium-Absorber) hin zu den Schottky-Kontaktbereichen zwischen der Absorberschicht **01** und den Emitterkontakten 03 infolge des bei der Solarzelle **00** nach der Erfindung örtlich variierten Dotierprofils.

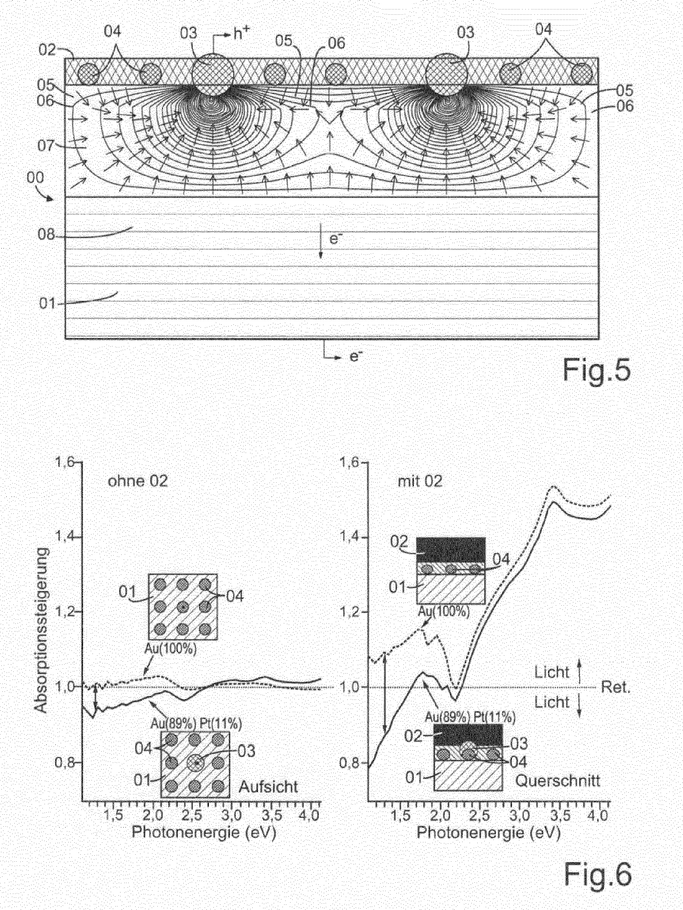

Die **Figur 5** zeigt die numerische Lösung der Poisson-Gleichung wieder unter der Annahme vollständiger Ladungsträgerverarmung in den Gebieten höherer bzw. niedrigerer Dotierung (full depletion approximation) sowie negativer Aufladung der sphärischen Metallstrukturen (Emitterkontakte **03,** plasmonisch aktive Nanopartikel **04**)**.** Die Darstellung gibt die Richtung der ortsabhängigen elektrischen Feldstärke so wieder wie in **Figur 4** angenommen. Die Feldstärke ist der Übersichtlichkeit halber normiert dargestellt.

Die optischen Eigenschaften der mit der Erfindung beschriebenen Lösung sind nachfolgend durch numerische Berechnung mit Hilfe der so genannten. "Finite Difference Time Domain" (FDTD) Methode erfasst. Die **Figur 6** zeigt das optische Verhalten Au- bzw. Au- und Pt-dekorierter Si-Dünnschichten (Schichtdicke zwischen 100 nm und 10 µm) als Absorberschicht **01** (Absorptionssteigerung (normiert) über der eingestrahlten Photonenenergie in eV). Die Ergebnisse in **Figur 6** zeigen die Zunahme der Absorption in der Si-Absorberschicht **01** über der eingestrahlten Photonenenergie beispielhaft in Gegenwart von plasmonisch aktiven Au-Nanopartikeln **04** bzw. Au-Partikeln und Pt-Emitterkontakten **03** (links) und die entsprechenden Ergebnisse nach Beschichtung (rechts) mit einem isolierenden Polymer (ZEP7000, Zeon Europe GmbH) für die Isolationsschicht **02.** Die waagerechte Gerade bei 1 dient somit als Referenzlinie: Werte oberhalb von 1 weisen auf eine Zunahme der Absorption in der Si-Absorberschicht **01,** Werte kleiner 1 auf eine Abnahme hin. In der linken oberen Darstellung bedecken (100%) 40 nm große Au-Nanopartikel **04** die Oberfläche der Absorptionsschicht **01.** Eine nur leichte Zunahme des Absorptionsvermögens ist erkennbar (obere Kurve im linken Bereich). Bei etwa 2,2 eV liegt das durch die plasmonische Resonanz erzeugte lokale Maximum der Absorptionszunahme. Das Hinzufügen eines 60 nm großen Pt-Emitterkontaktes **03** (linke untere Darstellung) senkt die Absorption besonders für Energien unterhalb von 2,7 eV. Im rechten Diagramm ist die Oberfläche der Absorptionsschicht **01** mit der Isolationsschicht **02** aus einem Polymer beschichtet (Schichtdicke 50 nm, ZEP7000, Brechungsindex etwa 1,5 bis 2). Die Resonanz der Au-Nanopartikel **04** ist hier deutlicher ausgeprägt (bei etwa 1,7 eV, obere Kurve). Je geringer die Dichte der Pt-Emitterkontakte **03** ist, umso mehr nähert sich die untere Kurve der oberen Kurve an.

Deutlich ist in **Figur 6** zu erkennen:
- Die Gegenwart von Pt-Partikeln als Emitterkontakte **03** wirkt sich nachteilig auf die Absorption aus (vergleiche jeweils die beiden Kurven in der linken bzw. rechten Darstellung). Die entsprechende Dichte der Emitterkontakte **03** muss daher stets minimiert werden.
- Die im linken Diagramm bei etwa 2,2 eV durch die Resonanz der Oberflächenplasmonen der Au-Nanopartikel **04** verursachte Absorptionszunahme (ohne Pt-Kontakte) wird durch die Gegenwart der (hier 50 nm dicken) Isolationsschicht **03** aus Polymer verstärkt und in Richtung 1,7 eV, also näher an die Si-Bandlücke von etwa 1,1 eV der Absorberschicht **01** verschoben (rechtes Diagramm).
- Mehrfachreflexionen durch die Isolationsschicht **03** wirken sich besonders für kleine Wellenlängen aus, die Absorptionszunahme in Richtung UV-Licht ist besonders ausgeprägt.

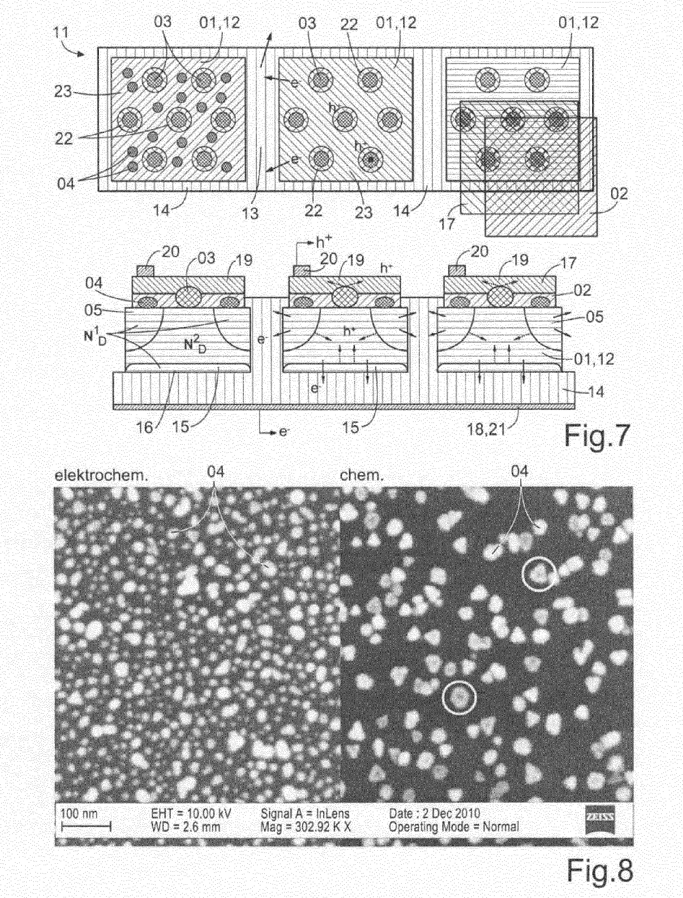

In der **Figur 7** ist in der Aufsicht (oben) und im Querschnitt (unten) eine flexible Solarzelle **11** nach der Erfindung dargestellt, bei der die Absorberschicht **01** als Wafer ausgebildet und in Einzelsegmente **12** aufgeteilt ist, die matrixartig mit Abständen **13** zueinander in eine flexible, elektrisch leitfähige Polymerschicht **14** eingelagert sind. Zu erkennen sind weiterhin die Emitterkontakte 03 und die plasmonisch aktiven Nanopartikel **04.** Dieses System folgt im Wesentlichen den zuvor gemachten Ausführungen. Zusätzlich ist noch ein weitere Raumladungszone **15** mit einer erhöhten Dotierkonzentration (N¹_{D}) gleichen Ladungsträgertyps an den Unterseiten **16** (lichtabgewandt) der Einzelsegmente **12** der Absorberschicht 01 vorgesehen. Diese zusätzliche Raumladungszone **15** wirkt als so genanntes "Back-surface-field" und dient der Beschleunigung lichtinduzierter überschüssiger Minoritätsladungsträger (bei einer n-Dotierung der Absorberschicht also Löcher h⁺) zur Frontkontaktierung **17** bzw. der Beschleunigung lichtinduzierter überschüssiger Majoritätsladungsträger (bei einer n-Dotierung der Absorberschicht also Elektronen e⁻) zur Rückkontaktierung **18** hin unterstützt. Die Frontkontaktierung **17** besteht aus einer einem transparenten, leitfähigen Oxid (TCO) **19** mit Frontkontakten **20,** beispielsweise aus Gold, in Linien- bzw. Finger- oder Punktform, die Rückkontaktierung **18** aus einer Metallschicht **21,** beispielsweise aus Aluminium.

Die zuvor nicht berücksichtigten Absenkungen der Schottky-Barrieren durch Bildladungen (eine Bildladung oder Spiegelladung ist eine gedankliche Hilfsstütze, um das Verhalten einer Ladung Q vor einem leitenden Körper im Abstand R zu veranschaulichen. Die gesamte influenzierte Ladung wird dafür anschaulich zu einer Punktladung zusammengefasst. Aus Symmetriegründen wird diese Punktladung als Spiegelladung bezeichnet) in Abhängigkeit von der Metall-Partikelgröße und der Dotierung des angrenzenden Si-Bereiches in der Absorberschicht **01** führen zu einem oberflächennahen Potenzialtrichter für Elektronen (bei n-Dotierung), der für kleine Metall-Partikel und für große Dotierungen ausgeprägter ist. Bei Überlappung der Raumladungszonen **05** unterhalb der plasmonischen Nanopartikel **04** können sich also einige Elektronen über weite Strecken entlang der Grenzfläche bewegen, während andere zur Rückkontaktierung **18** beschleunigt werden. Dies führt zu den in **Figur 7** oben Mitte angedeuteten Verhältnissen: die Emitterkontakte **03** sind von Ringflächen **22** umgeben, die durch die Flächen **23** der Raumladungszonen **05** der plasmonischen Partikel **04** vernetzt sind und eine oberflächenparallele Bewegung der Elektronen gestatten, bis sie in die leitende Polymerschicht **14** austreten.

Im Nachfolgenden wird die Herstellung einer Solarzelle **00** nach der Erfindung mit einem Siliziumwafer als Absorberschicht **01** zum weiteren Verständnis der Erfindung näher beschrieben.

Die Oberfläche (Oberflächenorientierung (111)) des Silizium-Wafers als Absorberschicht **01** wurde zunächst entsprechend vorausgegangener Untersuchungen vom Oxid befreit und mit Wasserstoff abgesättigt (H-Terminierung zur guten Oberflächenpassivierung). Als plasmonisch aktive Nanopartikel **04** wurden ca. 10 nm - 40 nm große Nanopartikel aus Gold (Au) chemisch auf der Oberfläche unter Verwendung einer Lösung, die im Verhältnis 1:1 aus konzentrierter Ammoniumfluoridlösung (NH₄F, 40%) und 0,001 M AuCl₄ zusammengesetzt ist, abgeschieden. Die Abscheidungszeit betrug etwa 20 s. In der **Figur 8** ist eine rasterelektronenmikroskopische Aufnahme von elektrochemisch (links) und chemisch (rechts) abgeschiedenen Au-Nanopartikeln **04** auf der Si(111)-Oberfläche der Absorberschicht **01** dargestellt. Typisch für die chemische Abscheidung ist die bevorzugte Bildung mehrheitlich nicht-sphärischer, sondern eher eckiger, insbesondere dreieckiger Nanopartikel **04,** wie sie in dem hier beschrieben Ausführungsbeispiel verwendet wurden.

Elektrochemisches Ätzen in 40% NH₄F kathodisch vom Ruhepotenzial (-0,6V vs. Ag/AgCl) für 200 s führte anschließend zum Abätzen des bei der Abscheidung der Au-Nanopartikel **04** gebildeten Oxids sowie zur Wasserstofferzeugung im Zuge beginnender Silizium-Auflösung, während die Au-Nanopartikel **04** an der Oberfläche der Absorberschicht **01** haftenblieben, wie Voruntersuchungen bestätigten. Weitere Untersuchungen ergaben, dass das so behandelte n-dotierte Silizium als Absorberschicht **01** eine deutlich höhere Elektronenkonzentration an der Oberfläche aufwies und sich seinem Verhalten nach dem Verhalten von höher n-dotiertem (n⁺) Silizium annäherte.

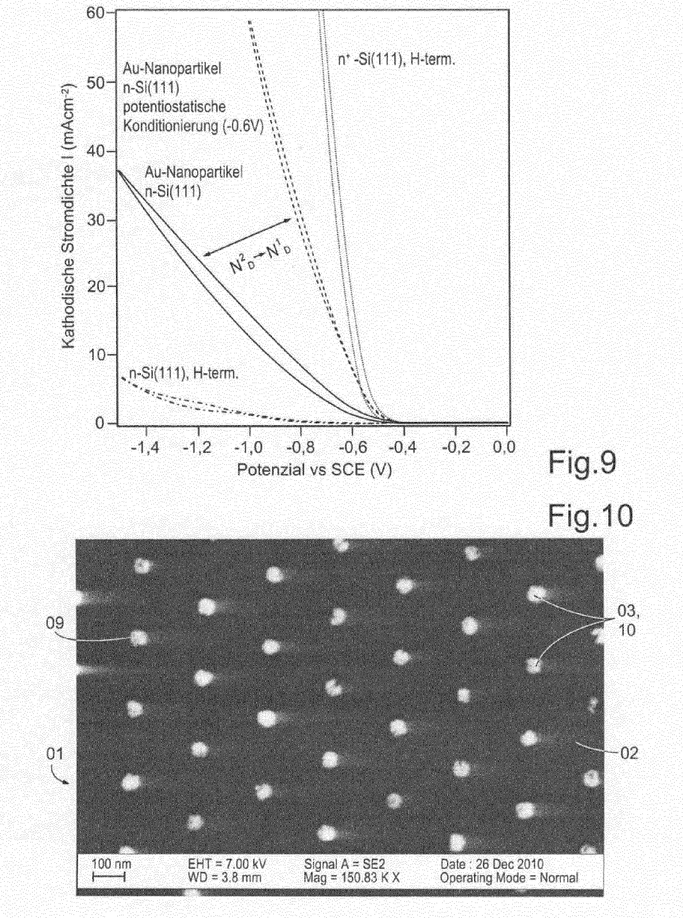

In der **Figur 9** ist die Erhöhung der Stromdichte in 1 M H₂SO₄ von Au/Si(111) nach kathodischem Ätzen (potenziostatische Konditionierung bei -0,6V) dargestellt (zweite Kurvenschar von rechts). Zum Vergleich ist der Stromverlauf von höherdotiertem (n⁺)- dotiertem Silizium, wasserstoffterminiert (rechte Kurvenschar), normaldotiertem Silizium, wasserstoffterminiert (linke Kurvenschar) sowie unbehandeltem Au/Si(111) (zweite Kurvenschar von links) gezeigt. Der Pfeil deutet die Zunahme der oberflächennahen Dotierung durch vorangegangene Diffusion von Wasserstoff in den Siliziumkristall der Absorberschicht **01** an (N²_{D} ⇒ N¹_{D}). Ursachen dieses Phänomens sind die bekannte Diffusion von Wasserstoff in den Siliziumkristall, die durch die Gegenwart der Au-Nanopartikel katalysiert wird, und die Erzeugung zusätzlicher elektronischer Niveaus (Donatoren) nahe der Leitungsbandkante der Silizium-Absorberschicht **01.** Für ausgedehnte Ätzzeiten sind diese Ergebnisse in **Figur 9** zusammengefasst.

Nach dieser Behandlung wurde der Siliziumwafer erneut für 5 s in die Gold-Lösung gedippt, um neben der zusätzlichen Abscheidung von Au-Nanopartikeln **04** auch das passivierende Oxid um die Nanopartikel herum wiederherzustellen. Dieser Schritt war notwendig, um eine Degradation des Silizium-wafers bis zur geplanten Polymer-Beschichtung zur Erzeugung der Isolationsschicht **02** zu vermeiden. Der so behandelte Siliziumwafer wurde dann mit einem kommerziell erhältlichen Polymer (ZEP7000, Zeon Europe GmbH) der Dicke 50 nm beschichtet. Diese polymere Isolationsschicht **02** wurde anschließend über Elektronenstrahllithographie (30 keV bzw. 100 keV) an hexagonal angeordneten Plätzen belichtet und anschließend in n-Hexylacetat entwickelt, sodass die darunter liegende Siliziumoberfläche der Absorberschicht 01 wieder frei gelegt wurde.

In der **Figur 10** ist eine rasterelektronenmikroskopische Aufnahme einer n-Silizium-Oberfäche der Absorberschicht **01** mit einer ZEP7000-Polymerschicht als Isolationsschicht **02** der Dicke 50 nm dargestellt, die zur Erzeugung der Emitterkontakte **03** mit hexagonal angeordneten 50 nm breiten Nanoporen **09** versehen wurde, die anschließend mit Platin Pt verfüllt wurden, sodass Nanoemitterkontakte **10** entstanden. Unterhalb der polymeren Isolationsschicht **02** wurden auf die Oberfläche der Absorberschicht **01** plasmonisch aktive Nanopartikel **04** (in der Figur 10 nicht sichtbar) aus Gold Au aufgebracht. Der Porendurchmesser nach dem Entwicklungsschritt betrug 50 nm. Über Rasterelektronenmikroskopie (REM) und energiedispersive Röntgenanalyse (EDX) konnten in den freigelegten Bereichen keine Au-Nanopartikel **04** mehr detektiert werden. Der Siliziumwafer wurde anschließend erneut in 40% NH₄F bei -0,6V so lange geätzt, bis eine erkennbare Stromdichte (30 µm Acm⁻²) die Entfernung des erneut gebildeten Oberflächenoxids anzeigte und eine bereits leichte Tiefenätzung am Ort der hexagonal angeordneten Löcher angenommen werden konnte. Diese Tiefenätzung trug darüber hinaus zuvor gebildete, höher dotierte Grenzschichten zumindest zum Teil ab und erzeugte das in **Figur 1** angenommene Dotierprofil zumindest näherungsweise. In die entstandenen Löcher wurde Platin aus wässriger 0,001 M ([PtCl₆]²⁻) - Lösung zur Bildung der Emitterkontakte **03** abgeschieden. Die lokale Abscheidung von Platin in die Porenbereiche konnte mit REM und EDX bestätigt werden.

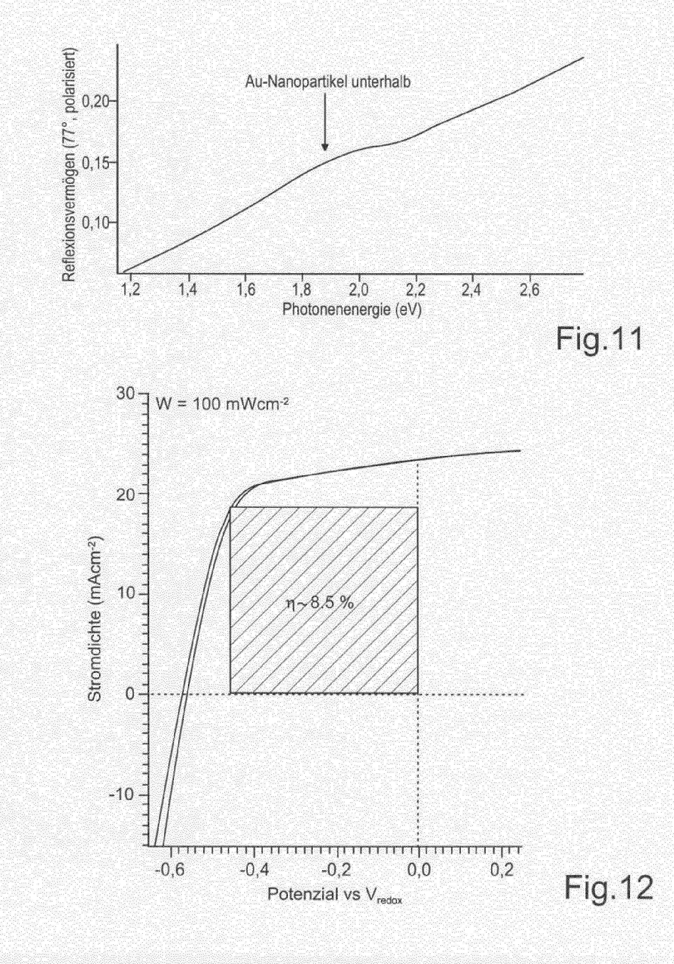

In der **Figur 11** ist das Reflexionsvermögen der Oberfläche der Absorberschicht 01 aus Silizium gemäß **Figur 9** für p-polarisiertes Licht unter einem Einfallswinkel von 77° dargestellt. Die lokale Resonanz bei 1,9 eV bestätigte die Präsenz der Au-Nanopartikel **04** unterhalb der polymeren Isolationsschicht **04.** Über ein winkelaufgelöstes Reflexionsverfahren konnte die Gegenwart der Au-Nanopartikel **04** durch Detektion der rot-verschobenen plasmonischen Au-Resonanz überprüft werden.

Die nach dem vorbeschriebenen Verfahren gefertige Solarzelle **00** wurde über ein InGa-Amalgam an der Rückseite kontaktiert und in einer Drei-Elektrodenanordnung als photoelektrochemische Solarzelle in einem Iodid-Triiodid Redox-Elektrolyten bei einer Beleuchtung von 100 mWcm⁻² getestet. Die Photostrom-Spannungskurve ist in **Figur 12** wiedergegeben (Stromdichte in mAcm⁻² über Potenzial gegenüber Redoxpotenzial). Die Auswertung der Effizienz dieses Systems mit der Solarzelle **00** nach der Erfindung ergab einen Wirkungsgrad von etwa 8,5%, der allein auf den elektronischen Maßnahmen (plasmonisch aktive Nanopartikel zwischen Nanoemitterkontakten und ein dazu korreliertes Dotierprofil in der Absorberschicht) beruht. Zusammen mit optischen Modifizierungen der Solarzelle **00** nach der Erfindung kann eine weitere Effizienzsteigerung bei der Umwandlung von eingestrahlter Photonenenergie in elektrischen Strom erzielt werden.

### Bezugszeichenliste

- **00**: Solarzelle
- **01**: Absorberschicht
- **02**: transparente Isolationsschicht
- **03**: Emitterkontakt
- **04**: plasmonisch aktiver Nanopartikel
- **05**: Raumladungszone mit Dotierkonzentration N¹_{D}
- **06**: Raumladungszonen mit Dotierkonzentration N¹_{D}- N²_{D}
- **07**: Front-Raumladungszone
- **08**: Absorberbereich mit Dotierkonzentration N²_{D}
- **09**: Nanopore
- **10**: Nanoemitterkontakt

- **11**: flexible Solarzelle
- **12**: Einzelsegment
- **13**: Abstand
- **14**: flexible, elektrisch leitfähige Polymerschicht
- **15**: weitere Raumladungszone
- **16**: Unterseite (lichtabgewandt)
- **17**: Frontkontaktierung
- **18**: Rückkontaktierung
- **19**: transparentes, leitfähiges Oxid
- **20**: Frontkontakt
- **21**: Metallschicht
- **22**: Ringfläche
- **23**: Fläche

## Patentansprüche

1. Solarzelle mit einem elektrischen Festkörperkontakt vom Schottkytyp zwischen einer Absorberschicht aus einem Halbleitermaterial mit einer Dotierkonzentration eines Ladungsträgertyps und einer Vielzahl von Emitterkontakten aus einem Metall, die eine auf der Absorberschicht angeordnete transparente Isolationsschicht aus einem elektrisch nichtleitenden Material durchdringen und in die darunter liegende Absorberschicht hineinragen, wobei die Emitterkontakte auf der lichtzugewandten Oberseite der Isolationsschicht durch eine Frontkontaktierung elektrisch leitend miteinander-verbunden sind, und mit einer Rückkontaktierung auf der lichtabgewandten Unterseite der Absorberschicht,
**dadurch gekennzeichnet, dass**
auf der Absorberschicht (01) zwischen den Emitterkontakten (03), die aus einem Metall mit keiner oder nur geringer plasmonischen Aktivität |α|ₘₐₓ in einem Bereich zwischen 1,0 und 1,2 bestehen, eine Vielzahl von Nanopartikeln (04), die aus einem Metall mit einer hohen plasmonischen Aktivität |α|ₘₐₓ in einem Bereich zwischen 1, 5 und 6,2 bestehen, angeordnet und von der Isolationsschicht (02) umgeben und überdeckt sind, wobei die Nanopartikel (04) nicht in die Absorberschicht (01) hineinragen, und unterhalb der plasmonisch aktiven Nanopartikel (04) in der Absorberschicht (01) eine gegenüber der Dotierkonzentration (N²_{D}) der Absorberschicht (01) höhere Dotierkonzentration (N¹_{D}) desselben Ladungsträgertyps vorgesehen ist, wohingegen unterhalb der Emitterkontakte (03) die unveränderte Dotierkonzentration (N²_{D}) der Absorberschicht (01) belassen ist.

2. Solarzelle nach Anspruch 1,
**dadurch gekennzeichnet, dass**
das Halbleitermaterial der Absorberschicht (01) kristallines Silizium mit einer Dotierkonzentration (N²_{D}) des n-Ladungsträgertyps in einem Bereich zwischen 10¹⁵ und 10¹⁶ Elektronen / cm³ ist.

3. Solarzelle nach Anspruch 1 oder 2,
**dadurch gekennzeichnet, dass**
die Absorberschicht (01) aus kristallinem Silizium als Dünnschicht mit einer Schichtdicke in einem Bereich zwischen 100 nm und 10 µm ausgeführt ist.

4. Solarzelle nach zumindest einem der vorangehenden Ansprüche,
**dadurch gekennzeichnet, dass**
unterhalb der plasmonisch aktiven Nanopartikel (04) eine Dotierkonzentration (N¹_{D}) des n-Ladungsträgertyps in einem Bereich zwischen 10¹⁷ und 10¹⁸ Elektronen / cm³ vorgesehen ist.

5. Solarzelle nach zumindest einem der vorangehenden Ansprüche,
**dadurch gekennzeichnet, dass**
das transparente elektrisch nichtleitende Material für die Isolationsschicht (02) ein Polymer mit einem Brechungsindex, der größer oder gleich 1,5, insbesondere gleich 2, ist.

6. Solarzelle nach zumindest einem der vorangehenden Ansprüche,
**dadurch gekennzeichnet, dass**
das Material für die Emitterkontakte (03) Platin ist.

7. Solarzelle nach zumindest einem der vorangehenden Ansprüche,
**dadurch gekennzeichnet, dass**
das Material für die plasmonisch aktiven Nanopartikel (04) Gold, Silber, Kupfer oder Aluminium ist.

8. Solarzelle nach zumindest einem der vorangehenden Ansprüche,
**dadurch gekennzeichnet, dass**
die Emitterkontakte (03) als Nanoemitterkontakte (10) ausgebildet sind, die in Nanoporen (09) in der Absorberschicht (01) und der Isolationsschicht (02) eingebracht sind.

9. Solarzelle nach zumindest einem der vorangehenden Ansprüche,
**dadurch gekennzeichnet, dass**
die Frontkontaktierung (17) von einer transparenten, elektrisch leitfähigen Oxidschicht (19) und darauf angebrachten Frontkontakten (20) und die Rückkontaktierung (18) von einer Metallschicht (21) gebildet ist.

10. Solarzelle nach zumindest einem der vorangehenden Ansprüche,
**dadurch gekennzeichnet, dass**
die Absorberschicht (01) in Waferausbildung in Einzelsegmente (12) aufgeteilt ist, die matrixartig mit Abständen (13) zueinander in eine flexible, elektrisch leitfähige Polymerschicht (14) eingelagert sind.
